(19) **Europäisches Patentamt**

**European Patent Office**

**Office européen des brevets**

(11) **EP 0 687 126 B1**

(12) **EUROPÄISCHE PATENTSCHRIFT**

(45) Veröffentlichungstag und Bekanntmachung des Hinweises auf die Patenterteilung:
**11.12.1996 Patentblatt 1996/50**

(51) Int Cl.6: **H04R 1/00**, H03H 17/02, H03G 5/16

(21) Anmeldenummer: **95108627.1**

(22) Anmeldetag: **06.06.1995**

(54) **Tonfrequenzfilter und Verfahren zur Bestimmung der Filterfunktion eines Tonfrequenzfilters**

Audio-frequency filter and method for determining the filtering function of an audio-frequency filter

Filtre à fréquences audio et méthode pour déterminer la fonction de filtrage d'un filtre à audiofréquences

(84) Benannte Vertragsstaaten:
**AT BE CH DE FR GB LI NL**

(30) Priorität: **07.06.1994 DE 4419819**

(43) Veröffentlichungstag der Anmeldung:
**13.12.1995 Patentblatt 1995/50**

(73) Patentinhaber: **Spang, Linda**
**D-30926 Seelze (DE)**

(72) Erfinder:
- **Spang, Linda**
  **D-30926 Seelze (DE)**
- **Stöxen, Oliver**
  **D-30926 Seelze (DE)**

(74) Vertreter: **Patentanwälte Thömen & Körner**
**Zeppelinstrasse 5**
**30175 Hannover (DE)**

(56) Entgegenhaltungen:
**GB-A- 2 181 626        GB-A- 2 252 023**

- **IEEE TRANSACTIONS ON ACOUSTICS, SPEECH AND SIGNAL PROCESSING, Bd. 36, Nr. 2, Februar 1988 NEW YORK US, Seiten 145-152, XP 000005739 MASATO MIYOSHI ET AL 'INVERSE FILTERING OF ROOM ACOUSTICS'**
- **IEICE TRANSACTIONS ON FUNDAMENTALS OF ELECTRONICS, COMMUNICATIONS AND COMPUTER SCIENCES, Bd. 75, Nr. 11, November 1992 TOKYO JP, Seiten 1468-1473, XP 000337093 P.NELSON ET AL 'INVERSE FILTERS FOR MULTI-CHANNEL SOUND REPRODUCTION'**

## Beschreibung

Die Erfindung betrifft einen Tonfrequenzfilter nach dem Oberbegriff des Anspruchs 1 und ein Verfahren zur Bestimmung der Filterfunktion eines Tonfrequenzfilters nach dem Oberbegriff des Anspruchs 8.

Die Wiedergabe von Audioquellen ist maßgeblich von der Linearität und Klangtreue der Einzelkomponenten abhängig. Diese Komponenten werden alle für sich auf optimalen Frequenz- und Phasengang ausgelegt. Prinzipbedingt bestimmt hauptsächlich das schwächste Glied in der Übertragungskette die Wiedergabequalität. Vor allem die Lautsprecher sind hierbei zu nennen. Neben Linearitätsfehlern im Frequenzgang, die u. a. aus der akustischen Fehlanpassung der Lautsprechermembran an die Luft resultieren, sind Phasenfehler durch die Filter zur Aufteilung des Signals auf die Tief- Mittel- und Hochtöner Ursache für Klangverfälschungen. Darüberhinaus beeinflußt auch der Aufstellungsort der Lautsprecher das Klangbild, indem Reflektionen zu einer Anhebung oder Absenkung bestimmter Spektralbereiche am Hörort führen.

Es ist bekannt, die Linearität von Übertragungskomponenten durch Gegenkopplung zu verbessern. Bezogen auf eine Tonfrequenzwiedergabeanlage mit Lautsprechern wurden Versuche unternommen, die Gegenkopplung mittels eines in unmittelbarer Nähe der Lautsprecher angebrachten Mikrofons, dessen Signal über ein Filter gegenphasig auf den Verstärkereingang gekoppelt wird, zu realisieren. Da hierbei aber eine enge Kopplung an den Lautsprecher erforderlich ist, läßt sich der störende Einfluß der Raumakustik nicht kompensieren.

Aus der DE 40 11 704 A1 ist eine Anordnung zur Verbesserung der Wiedergabequalität von Audiosignalen bekannt. Dabei wird ein Filter mit einem steuerbaren Frequenzgang verwendet. Mit Hilfe eines Rauschgenerators wird ein schmalbandiges Rauschsignal auf einen Lautsprecher gegeben und das vom Lautsprecher abgestrahlte Rauschen von einem Mikrofon aufgenommen. Die Ausgangssignale des Mikrofons werden verstärkt und hüllkurvendemoduliert. Die so erhaltene jeweilige Amplitude wird mit Hilfe eines Analog/Digitalwandlers in ein digitales Signal umgewandelt und einem Rechenwerk zugeführt. Mit Hilfe des Rechenwerks werden Koeffizienten einer Filterfunktion bestimmt, so daß der Betrag der Inversen des gemessenen Frequenzgangs im Frequenzbereich der Audiosignale möglichst approximiert wird. Bei der beschriebenen Anordnung wird ausschließlich der Amplitudenfrequenzgang für die Audiosignale korrigiert, nicht jedoch der den Höreindruck entscheidend mitprägende Phasenfrequenzgang.

Ferner ist aus der DE 41 11 276 A1 ein Verfahren zur Korrektur linearer Verzerrungen elektroakustischer Wandler bekannt, bei der der Frequenzgang durch eine Kombination aus einem rekursiven und einem nichtrekursiven Digitalfilter kompensiert wird. Das rekursive Filter dient ausschließlich zur Baßentzerrung, wobei hier ausschließlich der Amplitudenfrequenzgang berücksichtigt wird. Das nichtrekursive Filter dient zur Kompensation des Amplituden- und Phasenfrequenzganges des Lautsprechers, allerdings nur für den Bereich oberhalb seiner Grenzfrequenz. Bei der Kompensation wird ausschließlich der Frequenzgang eines Lautsprechers, nicht jedoch der Frequenzgang des Gesamtsignalweges kompensiert. Somit lassen sich weder Fehler korrigieren, die durch ein Mehr-Wege-Lautsprechersystem hervorgerufen werden, noch Fehler, die auf dem akustischen Signalweg zwischen dem elektroakustischen Wandler und dem Hörort auftreten.

Aus der GB 2 252 023 A ist außerdem ein Mehrkanalübertragungssystem für Audioanwendungen bekannt, bei dem die durch Filterweichen und sonstige Einflüsse des Übertragungsweges entstehenden Amplituden- und Phasenänderungen durch inverse Filter kompensiert werden sollen. Mit der Kompensation soll erreicht werden, daß zwischen Eingang und Ausgang ein ausgeglichener Amplitudengang- und eine lineare Phasenbeziehung besteht. Bei Anwendung des Mehrkanalübertragungssystems mit Lautsprechern in einer Box sollen ferner die Schallausbreitungen der unterschiedlichen Lautsprecher so angeglichen werden, daß die Phasenlagen sämtlicher Kanäle übereinstimmen.

In IEEE Transactions on Acoustics, Speech and Signal Processing, Band 36, Nr. 2, Februar 1988, Seiten 145-152, Masato Miyoshi et al, "Inverse Filtering of Room Acoustics", ist ausgeführt, daß eine vollständige Kompensation der Übertragungscharakteristik zwischen einem Hörort und einer Schallquelle in einem Raum mit einem einzigen Filter nicht möglich ist. Vielmehr gelingt dies erst, wenn die Übertragungsstrecke in zwei Kanäle aufgeteilt und jeder Kanal mit Filtern ausgestattet wird. Die Filter der beiden Kanäle müssen so bemessen sein, daß sie keine gemeinsamen Nullstellen aufweisen. Ferner muß die Summe der beiden Produkte aus der Übertragungsfunktion des jeweiligen Kanals und der Übertragungsfunktion des dem Kanal jeweils zugeordneten Kompensationsfilter den Wert 1 ergeben.

Auf der Basis der in dieser Druckschrift angegebenen Kompensationsmethode befaßt sich die IEICE Transactions on Fundamentals of Electronics, Communication and Computer Sciences, Band 75, Nr. 11, November 1992, Seiten 1468-1473, P. Nelson et al, "Inverse Filters for Multi-Channel Sound Reproduction" mit der Reduktion von Übersprechen bei Mehrkanalübertragungsanlagen.

Schließlich ist noch aus der GB 2 181 626 A ein Audiosignalanalyse und -verarbeitungssystem bekannt. Hierbei wird mittels einer Analyseeinheit das Spektrum des ankommenden Signals analysiert und auf der Basis dieser Analyse eine Verarbeitungseinheit in Form einer Filterweiche gesteuert. Die Steuerung erfolgt z. B. so daß bei Analyse eines schmalen Spektrums das Signal lediglic auf einen der Kanäle geschaltet wird, während es bei einem breiten Spektrum auf mehrere Kanäle aufgeteilt wird.

Der Erfindung liegt die Aufgabe zugrunde, ein Tonfrequenzfilter anzugeben, welches sämtliche den Frequenzund Phasengang verfälschende Einflüsse einer Tonfrequenzwiedergabeanlage einschließlich des akustischen Übertragungsweges bis zum Hörort kompensiert.

Diese Aufgabe wird bei einem Tonfrequenzfilter nach dem Oberbegriff des Anspruchs 1 durch die im Kennzeichen angegebenen Merkmale gelöst.

Das erfindungsgemäße Tonfrequenzfilter kommt ohne Gegenkopplung aus, so daß auch der Übertragungsweg zwischen den Schallwandlern und dem Hörort mit in die Kompensation einbezogen wird. Dabei kann sowohl der Amplitudengang als auch der Phasengang über den gesamten Signalweg korrigiert werden. Einflüsse durch fremde Schallquellen, die bei einer dynamischen Gegenkopplung in unerwünschter Weise das Gegenkopplungssignal verfälschen, sind ausgeschlossen. Außerdem wird der Amplitudenfrequenzgang der Filterfunktion durch Kehrwertbildung der von Null verschiedenen Bereiche des Amplitudenfrequenzganges des Gesamtsignalweges bestimmt. Hierdurch wird vermieden, daß die durch Kehrwertbildung erzeugte Übertragungsfunktion sehr große Werte annehmen kann, was einer praktischen Realisierung des Tonfreqenzfilters entgegenstehen würden.

Weiterhin ist vorgesehen, daß der Filterblock als Digitalfilter ausgebildet ist, das durch eine Frequenzweiche in einen Tieftonweg und ein Mittel- und Hochtonweg aufgeteilt ist und daß im Tieftonweg eine Unterabtastung erfolgt.

Dabei kann der Mittel- und Hochtonweg einen ersten Hochpaß, ein Mittel- und Hochton-Kompensationsfilter und einen zweiten Hochpaß umfassen und der Tieftonweg ein erstes Tiefpaßfilter, eine Unterabtaststufe, ein Tieftonkompensationsfilter, eine Überabtaststufe und ein zweites Tiefpaßfilter umfassen.

Eine gute Kompensation setzt voraus, daß die Sprung- oder Impulsantwort in ihrer gesamten Länge ausgewertet wird. Hierbei müssen aber aufgrund der durch die höchsten Nutzfrequenzen bedingten hohen Abtastfrequenz eine große Anzahl Abtastwerte ausgewertet und berechnet werden, so daß ein hoher Rechenaufwand bei langer Rechenzeit erforderlich ist. Da die Länge der Sprung- oder Impulsantwort in erster Linie von niedrigen Frequenzkomponenten bestimmt wird, zu deren Nachbildung eine geringere Abtastfrequenz ausreichen würde, gelingt es mit der angegebenen Maßnahme, auch lange Sprung- oder Impulsantworten bei guter Genauigkeit mit reduziertem Rechenaufwand auszuwerten.

Dient das Tonfrequenzfilter zur Verwendung in einer Stereoanlage, so kann jeder Kanal einen gesonderten Filterblock umfassen. Zwischen dem Eingang des Filterblockes block umfassen. Zwischen dem Eingang des Filterblockes des einen Kanals und dem Ausgang des Filterblockes des anderen Kanals ist jeweils ein weiterer Filterblock angeordnet und die Filterfunktion der weiteren Filterblöcke sind so berechnet, daß sie das kreuzweise Übersprechen zwischen den Kanälen des gesamten Signalweges kompensieren.

Dadurch gelingt es, auch mit Lautsprechern als elektroakustischen Wandlern eine Kanaltrennung und damit eine Transparenz des Klangbildes zu erzeugen, wie sie sonst nur bei Wiedergabe über Kopfhörer erreichbar ist.

Bei Ausbildung des Tonfrequenzfilters als digitales Filter ist ein Signalprozessor mit Speichern sowie einen Tiefpaß mit anschließendem Analog-Digital-Wandler am Eingang und einen Digital-Analog-Wandler mit anschließendem Tiefpaß am Ausgang vorgesehen. Der Speicher enthält ein den Signalprozessor steuerndes Filterprogramm und die Filterfunktion definierende Filterkoeffizienten.

Der Vorteil eines digitalen Filters besteht darin, daß ohne Änderung der Hardware-Komponenten die Einstellung des Filters allein über die die Filterfunktion definierenden Filterkoeffizienten programmgesteuert erfolgt. Eine Änderung des Filters zur Anpassung an andere akustische Gegebenheiten, z.B. bei Aufstellung der Schallwandler an einem anderen Ort, ist somit ohne Eingriff in die Hardware des Tonfrequenzfilters möglich.

Die Filterfunktion wird näherungsweise durch ein gebrochen rationales Polynom der Form

$$A(z) = \frac{a_0 + a_1 z^{-1} + a_2 z^{-2} + \ldots + a_{N-1} z^{-(N-1)} + a_N z^{-N}}{1 + b_1 z^{-1} + b_2 z^{-2} + \ldots + b_{N-1} z^{-(N-1)} + b_N z^{-N}}$$

dargestellt. Das Filter selbst kann als FIR (Finite-Impuls-Response-Filter) oder als IIR (Infinite-Impuls-Response-Filter) ausgestaltet sein. Das einfacher zu realisierende FIR-Filter ist geeignet, wenn die in Vorversuchen ermittelte Sprung- oder Impulsantwort kurz ist. Im Falle des FIR-Filters werden die Filterkoeffizienten im Nenner des Polynoms zu Null, so daß die Filterfunktion als

$$A(z) = a_0 + a_1 z^{-1} + a_2 z^{-2} + \ldots + a_{N-1} z^{-(N-1)} + a_N z^{-N}$$

darstellbar ist.

In einer praktischen Ausführung wird die Ordnungszahl des Filters entsprechend der Anzahl der Filterkoeffizienten gerade so groß bemessen, daß die Abweichung vom realen Frequenzgang maximal 3 DB betragen.

Es ist dadurch möglich, bei der Realisierung der Hardware die Taktfrequenz des Signalprozessors und die Speicherkapazität der das Programm sowie die Filterkoeffizienten speichernden Filter so auszulegen, daß kostengünstige Bauelemente eingesetzt werden können, ohne daß dabei vom Höreindruck her Abweichungen gegenüber dem theoretischen Idealwert bemerkt werden können.

Bei einem Verfahren zur Bestimmung der Filterfunktion eines Tonfrequenzfilters liegt der Erfindung die Aufgabe zugrunde, ein Verfahren anzugeben, das präzise die Eigenschaften des Übertragungsweges ermittelt und automatisch die Filterkoeffizienten zur Einstellung des Filters gewinnt, mit dem die ermittelten Fehler des Übertragungsweges kompensiert werden können.

Diese Aufgabe wird bei einem Verfahren nach dem Oberbegriff des Anspruchs 8 durch die im Kennzeichen angegebenen Merkmale gelöst.

Das erfindungsgemäße Verfahren ermöglicht es, durch eine einmalige, kurze Messung einer Signalantwort eines die gesamte Übertragungsstrecke durchlaufenden Meßsignals die nötigen Daten zu ermitteln, aus denen durch Rechnung dann die Filterkoeffizienten bestimmt werden. Dazu wird neben der Tonfrequenzwiedergabeanlage in ihrer Betriebsaufstellung lediglich ein Signalgenerator als Signalquelle, ein Mikrofon und ein mit einem Auswerteprogramm ladbarer Rechner benötigt. Anstelle eines externen Signalgenerators kann auch der digitale Signalprozessor des digitalen Filters die benötigten Signale erzeugen. Mit dem Rechner kann im Anschluß an die Errechnung der Filterkoeffizienten auch gleichzeitig die Speicherung und damit die Programmierung des digitalen Filters erfolgen. Die Funktionen von Rechner und Signalgenerator können auch vom Signalprozessor übernommen werden.

Das Meßsignal kann eine Sprungfunktion oder eine Impulsfunktion der zeitlichen Länge größer Null sein und die nach Durchlaufen des unkorrigierten Gesamtsignalweges am Hörort erhaltene Sprung- oder Impulsfunktion wird differenziert.

Die Verwendung einer Sprungfunktion oder einer Impulsfunktion der zeitlichen Länge größer Null als Meßsignal erlaubt eine wesentlich energiereichere Messung als direktes Messen einer Impulsantwort nach einer Stoßfunktion. Dadurch ergibt sich ein besseres Signal mit weniger Rauschen und anderen Störanteilen. Eine Impulsantwort aus einer Stoßfunktion würde eine um den Faktor fünf bis zehn kleinere Amplitude liefern.

Vorzugsweise wird die differenzierte Sprung- oder Impulsantwort mit einer an der Seite sanft auslaufenden Fensterfunktion multipliziert, deren zeitliche Länge kleiner oder gleich der Periode der Fourier-Transformation ist. Dadurch wird sichergestellt, daß die Sprung- oder Impulsantwort bei der anschließenden Fourier-Transformation periodisiert werden kann, ohne daß durch das einfache Abschneiden der Sprung- oder Impulsantwort Fehler im Frequenzbereich entstehen. Bei einer Fourier-Transformation wird immer von periodisch fortgesetzten Signalen ausgegangen. Sind die Signale nicht periodisch, so müssen sie mit der Periode der Fourier-Transformation periodisiert werden. Fehler, die entstehen können, wenn die Sprung- oder Impulsantwort innerhalb der für die Fourier-Transformation möglichen Länge noch nicht abgeklungen ist, werden durch die erfindungsgemäße Maßnahme vermieden. Dadurch kann darauf verzichtet werden, die Länge der Periode der Fourier-Transformation aus Sicherheitsgründen höher zu wählen, was dann einen wesentlich höheren Rechenaufwand zur Folge hätte.

Außerdem kann die nach Rücktransformation in den Zeitbereich erhaltene Signalantwort, die die Signalantwort des korrigierenden Tonfrequenzfilters darstellt, mit einer weiteren, an beiden Seiten sanft auslaufenden Fensterfunktion multipliziert werden, wenn die zeitliche Länge kleiner oder gleich der Periode der Fourier-Transformation ist.

Da durch die Fourier-Transformation eine periodische Sprung- oder Impulsantwort erzeugt wird, muß aus der Folge der Sprung- oder Impulsantworten ein Bereich herausgeschnitten werden. Durch Verwendung der Fensterfunktion wird die Sprung- oder Impulsantwort nicht nur einfach an den Wänden abgeschnitten, sondern läuft sanft aus. Die Phase des Wunschfrequenzganges kann an die Phase der in den Frequenzbereich transformierten Signalantwort angepaßt werden, indem der Wunschfrequenzgang mit Phase Null in den Zeitbereich transformiert wird, anschließend um eine halbe Periode der Fourier-Transformation verschoben wird und anschließend in den Frequenzbereich zurücktransformiert wird. Dadurch ist sichergestellt, daß die Sprung- oder Impulsantwort nach Durchführung der inversen Fourier-Transformation die richtige Phasenlage erhält.

Weiterhin ist vorgesehen, daß der Frequenzgang eines zur Messung benutzten Meßaufnehmers invertiert und mit dem Wunschfrequenzgang multipliziert wird.

Auf diese Weise lassen sich Fehler, die durch eine ungleichmäßigen Frequenzgang des Meßaufnehmers verursacht werden, kompensieren. Wenn die Frequenzgänge von mehreren möglichen Meßaufnehmern aus Vorversuchen bekannt sind, lassen sich die Frequenzgänge auch zwischenspeichern und bei Einsatz eines bestimmten Meßaufnehmers abrufen.

Weiterhin ist vorgesehen, daß mehrere Messungen mit unterschiedlichen Signalpegeln durchgeführt werden und daraus eine Aussteuerungskennlinie ermittelt wird. Durch Division einer Idealkennlinie durch die Aussteuerungskennlinie wird eine Linearisierungsfunktion gewonnen und gespeichert, mit der anschließend die Signalamplitude des Nutzsignal multipliziert wird.

Durch diese Maßnahme lassen sich nichtlineare Eigenschaften des Signalweges, also eine nichtlineare Beziehung zwischen Aussteuerung und Wiedergabepegel kompensieren.

Weiterbildungen und vorteilhafte Ausgestaltungen der Erfindung ergeben sich aus den Ansprüchen, der weiteren Beschreibung und der Zeichnung, anhand der die Erfindung erläutert wird.

In der Zeichnung zeigen:

Fig. 1 ein Blockschaltbild der erfindungsgemäßen Tonfrequenzwiedergabeanlage

Fig. 2    ein Blockschaltbild eines Filterblocks mit einem Tieftonweg und einem Mittel-Hochtonweg,

Fig. 3    Frequenzgänge des Tiefton- und des Mittel- und Hochtonweges,

Fig. 4    ein Blockschaltbild zur Kompensation von Übersprechen bei Stereoanlagen,

Fig. 5    ein Blockschaltbild eines Filterblockes

Fig. 6 a - hSignal- und Frequenzdiagramme zur Veranschaulichung des Verfahrens zur Bestimmung der Filterfunktion.

Fig. 7    ein Signaldiagramm, welches die Behandlung der differenzierten Sprungantwort aus Fig. 3c mit einer Fensterfunktion darstellt,

Fig. 8    ein Frequenz- und Signaldiagramm, welches die Behandlung der Sprungantwort nach Fig. 3h mit einer Fensterfunktion zeigt und

Fig. 9    ein Frequenz- und Signaldiagramm zur Veranschaulichung der Phasenanpassung des Wunschfrequenzganges.

Fig. 10   ein Diagramm zu Darstellung einer Linearisierungsfunktion für die Aussteuerung

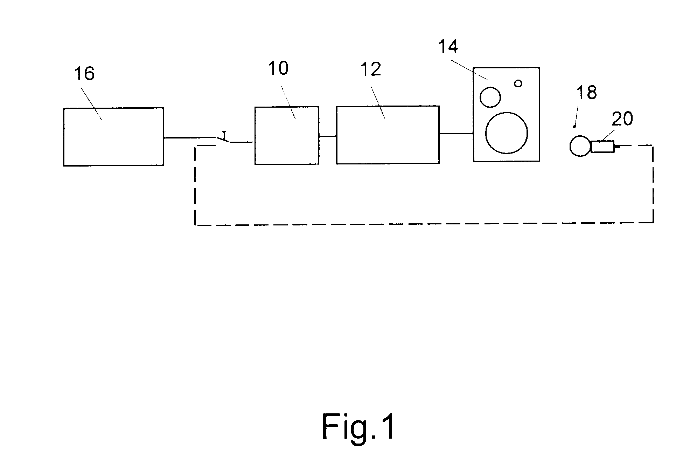

In Fig. 1 ist eine Tonfrequenzwiedergabeanlage aus einem Verstärker 12 und einem Schallwandler 14 dargestellt. Zur Kompensation des Amplituden- und Phasenfrequenzganges dient das erfindungsgemäße Tonfrequenzfilter 10, das in den Übertragungsweg einbezogen ist. Dieses Filter 10 kompensiert Fehler, die auf dem Übertragungsweg von einer Signalquelle 16 zu einem Hörort 18 entstehen, so daß bei richtigen Abgleich des Filters 10 der Phasen- und Frequenzgang am Hörort 18 der gleiche ist wie am Ausgang der Signalquelle 16.

Für eine einmalige Messung der Sprung- oder Impulsantwort der gesamten Übertragungsstrecke ist ein Mikrofon 20 dargestellt, das das am Hörort auftretende Signal zur Ermittlung der Filterkoeffizienten aufnimmt und einem Rechner 22 zur Auswertung zuführt. Dieses Mikrofon 20 ist nur während der einmaligen Messung der Sprung- oder Impulsantwort erforderlich und nicht zu verwechseln mit einem ständig im Gegenkopplungsweg liegenden Mikrofon beim Stand der Technik. Um dies auch grafisch zu verdeutlichen, ist der entsprechende Signalweg gestrichelt dargestellt ist. Während der Messung ist das Filter nicht aktiv.

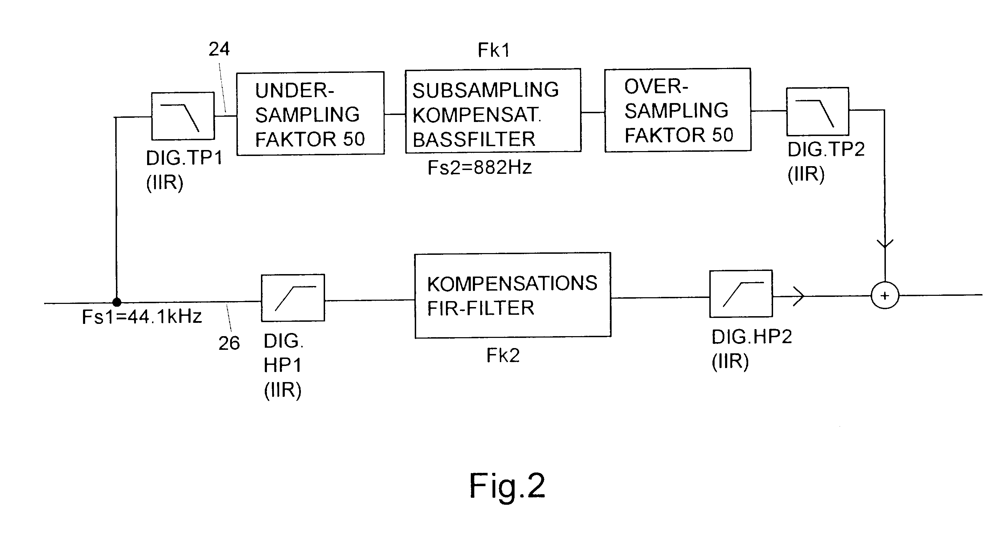

In Fig. 2 ist ein Filterblock dargestellt, der einen Tieftonweg 24 und einen Mittel-und Hochtonweg 26 umfaßt.

Im Mittel- und Hochtonweg 26 ist ein erster, als Frequenzweiche dienender Hochpaß HP1, ein Mittel- und Hochtonkompensationsfilter FK2 und ein zweiter, eine weitere Frequenzweiche bildender Hochpaß HP2 angeordnet. Der Tieftonweg 24 umfaßt ein als Frequenzweiche dienenden Tiefpaß TP1, eine Unterabtaststufe US, einen Tiefton-Kompensationsfilter FK1, eine Überabtaststufe ÜS und ein weiteres Tiefpaßfilter TP2, das eine zweite Frequenzweiche bildet. Die Tiefpaß- und Hochpaßfilter sind als IIR-Filter ausgebildet, während das Tiefton FK1 und das Mittel- und Hochton-Kompensationsfilter FK2 als FIR-Filter ausgebildet sind. Die Unterabtaststufe US und die Überabtaststufe US arbeiten im Ausführungsbeispiel mit dem Faktor 50.

Die Abtastwerte mit der bei Audiosignalen üblichen Abtastfrequenz von 44,1 kHz gelangen zum Eingang des Filters. Die mittel- und hochfrequenten Komponenten werden im Mittel- und Hochtonweg 26 mit derselben Abtastfrequenz verarbeitet. Dagegen wird von den Abtastwerten der tieffrequenten Komponenten in der Unterabtaststufe nur jeder 50. Abtastwert übernommen und vom Tiefton-Kompensationsfilter FK1 mit einer Abtastfrequenz von 882 Hz verarbeitet und anschließend wird durch eine Überabtastung jeder Wert 50 mal nacheinander übertragen, damit wieder die ursprüngliche Abtastfrequenz von 44,1 kHz vorliegt. Die Signale werden nach Durchlaufen der beiden Wege an einer Additionsstelle wieder zusammengeführt. In beiden Wegen wird die Ermittlung einer Filterfunktion gesondert vorgenommen. Dabei reduziert sich der Rechenaufwand im Bereich der tiefen Frequenzen um den Faktor 50. Die als Frequenzweichen dienenden Hochpaß- und Tiefpaßfilter sind als IIR-Filter realisiert. Ein linearphasiges Verhalten dieser Filter ist nicht erforderlich, da dies durch die Kompensationsfilter des jeweiligen Zweiges ausgeglichen wird.

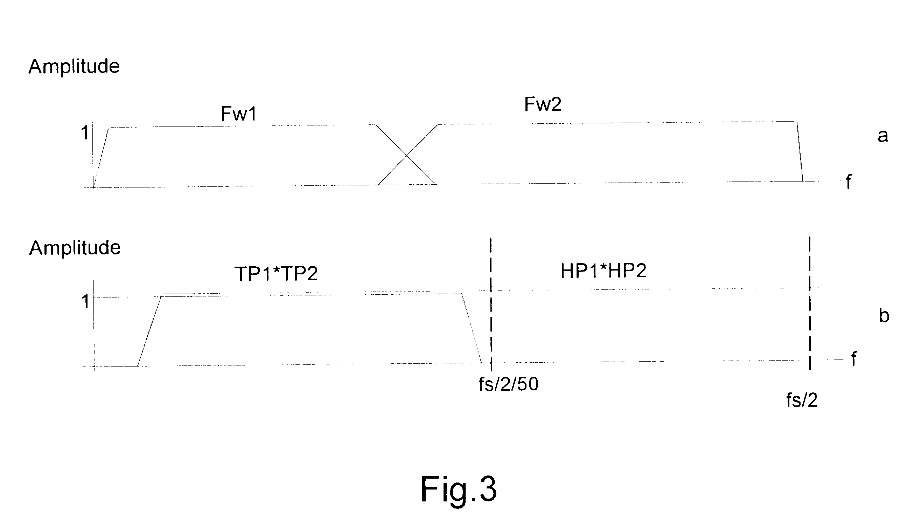

In Fig. 3 a ist der Wunschfrequenzgang im Tieftonweg FW1 und der Wunschfrequenzgang im Mittel- und Hochtonweg FW2 dargestellt. Es gilt folgende mathematische Beziehung: FW1 + FW2 = FWgesamt als gesamter Wunschfrequenzgang. Die Wunschfrequenzgänge FW1 und FW2 sind dabei so zu wählen, daß die Kompensationsfilter nicht unnötigerweise den Bereich im Frequenzgang linealisieren, für den sie nicht zuständig sind.

Fig. 3 b zeigt noch die Frequenzgänge der Tiefpässe TP1 und TP2 sowie der Hochpässe HP1 und HP2 sowie der Lage der halben Abtastfrequenz FS1 für den Mittel- und Hochtonweg 26 und der halben Abtastfrequenz FS2 für den Tieftonweg 24.

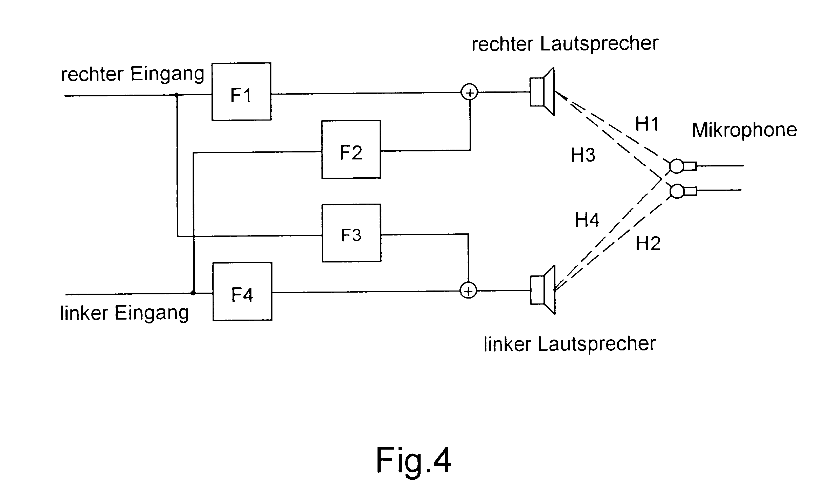

Fig. 4 zeigt ein Ausführungsbeispiel für ein Tonfrequenzfilter bei einer Stereoanlage mit zwei Kanälen. Die Darstellung beschränkt sich hier auf die Filterblöcke sowie die elektroakustischen Wandler und die Meßwertaufnehmer. In dem rechten Kanal R ist ein erster Filterblock F1 und im linken Kanal L ein erster Filterblock F4 angeordnet. Zwischen dem Eingang des ersten Filterblocks F1 und dem Ausgang des zweiten Filterblocks F4 liegt ein erster weiterer Filterblock F3 und zwischen dem Eingang des zweiten Filterblocks F4 und dem Ausgang des ersten Filterblocks F1 liegt ein zweiter weiterer Filterblock F3. Ausgangsseitig sind die Signalwege der Filterblöcke über Additionsstellen zusammengeführt. Die Übertragungsfunktionen der Übertragungswege von den elektroakustischen Wandlern zu den Meßwertaufnehmern sind mit H1 für den rechten Kanal und H2 für den linken Kanal bezeichnet und werden durch die Übertragungsfunktionen H3 und H4 für die jeweilige kreuzweise Beeinflussung ergänzt.

Die Übertragungsfunktionen H1 bis H4 werden aus den Messungen mit dem Meßsignal und nachfolgender Fouriertransformation gewonnen. Es wird also wieder der gesamte Signalweg in die Messung einbezogen. Werden die den Frequenzgang verfälschenden Signalwege auf den Weg zwischen elektroakustischer Wandler und Meßwertaufnehmer reduziert, so gelten folgende Beziehungen: Es gilt für eine Kompensation

$$F1 * H1 + F3 * H4 = 1$$

$$F4 * H2 + F2 * H3 = 1$$

und

$$F1 * H3 + F3 * H2 = 0$$

$$F4 * H4 + F2 * H1 = 0$$

Durch Umformen und Einsetzen ergibt sich

$$F1 = H2 / (H1 * H2) - (H3 * H4)$$

$$F3 = H3 / (H3 * H4) - (H1 * H2)$$

$$F4 = H1 / (H1 * H2) - (H3 * H4)$$

$$F2 = H4 / (H3 * H4) - (H1 * H2)$$

Vor dem Berechnen der Filter sind allerdings Korrekturen erforderlich, da eine vollständige Kompensation unerwünscht ist. So beträgt wegen der Schallausbreitungsgeschwindigkeit von 300 m/s die Wellenlänge bei 1 kHz nur ca. 30 cm. Ist der Hörort z. B. nur 15 cm neben dem Meßort, überlagern sich die von den elektroakustischen Wandlern ausgehenden Signale schon ein 1 kHz nicht so, daß sie sich auslöschen, sondern sie verstärken sich. Vor dem Berechnen werden die Übertragungsfunktionen H3 und H4 daher mit einem Tiefpaß gefiltert. Zusätzlich wird durch die Multiplikation mit einem Faktor K zum Abschwächen die Kompensation nur soweit durchgeführt, daß außerhalb des Meßortes nicht zu viele störende Anteile entstehen. Somit ergeben sich modifizierte Übertragungsfunktionen

$$H3' = H3 * TP * K$$

$$H4' = H4 * TP * K$$

Dies führt dann zu den modifizierten Gleichungen

$$F1' = H2 / (H1 * H2) - (H3' * H4')$$

$$F3' = H3' / (H3' * H4') - (H1 * H2)$$

$$F2' = H1 / (H1 * H4) - (H3' * H4')$$

$$F4' = H4' / (H3' * H4') - (H1 * H2)$$

Die Filterfunktionen F1, F2, F3' und F4' müssen vor der Rücktransformation in den Zeitbereich mittels inverser Fouriertransformation noch mit dem Wunschfrequenzgang multipliziert werden. Soll zusätzlich noch der Einfluß des Meßsensors berücksichtigt werden, so sind H1, H2, H3' und H4' noch mit dem inversen Frequenzgang des Meßsensors zu multiplizieren.

Besteht keine Kopplung zwischen dem linken und rechten Kanal, so sind die Übertragungsfunktionen H3 und H4 = 0. Dann ergibt sich

$$F1' = 1 / H1$$

und

$$F4' = 1 / H2$$

sowie

$$F2' \text{ und } F3' = 0$$

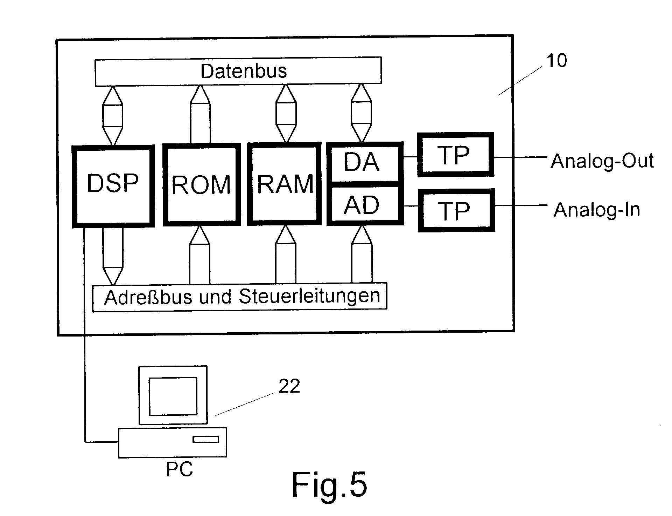

Fig. 5 zeigt ein Ausführungsbeispiel des digitalen Filters 10. Von einem Analog-Eingang E wird das Eingangssignal über einen Tiefpaß TP und einen daran anschließenden Analog-Digital-Wandler AD eingespeist. Das digitale Signal wird dann vom digitalen Signalprozessor DSP entsprechend der Übertragungsfunktion verarbeitet, das heißt im Falle eines FIR-Filters werden die digitalen Abtastwerte mehreren Multiplikationen mit den Filterkoeffizienten und mehreren Additionen unterworfen. Das verarbeitete Ausgangssignal gelangt dann über einen Digital-Analog-Wandler DA und einen daran anschließenden Tiefpaß TP zu einem Ausgang A.

Der Signalprozessor DSP muß schnell genug sein, um die erforderlichen Multiplikationen und Additionen innerhalb der Abtastzeit von bei Audiosystemen typischen 44 KHz vorzunehmen. Die Filterkoeffizienten sind in einem Schreib-Lese-Speicher RAM des Speichers untergebracht, wo sie nach der Messung und Berechnung gespeichert werden. Das eigentliche Filterprogramm ist in einem Nur-Lese-Speicher ROM abgelegt.

Zusätzlich ist ein externer Rechner 22 dargestellt, der in einem ersten Schritt zur Messung und Berechnung der Filterkoeffizienten dient. Nach Ausführung der Koeffizientenberechnung werden die Filterkoeffizienten zum Signalprozessor übertragen, wo dieser sie im Schreib-Lese-Speicher ablegt.

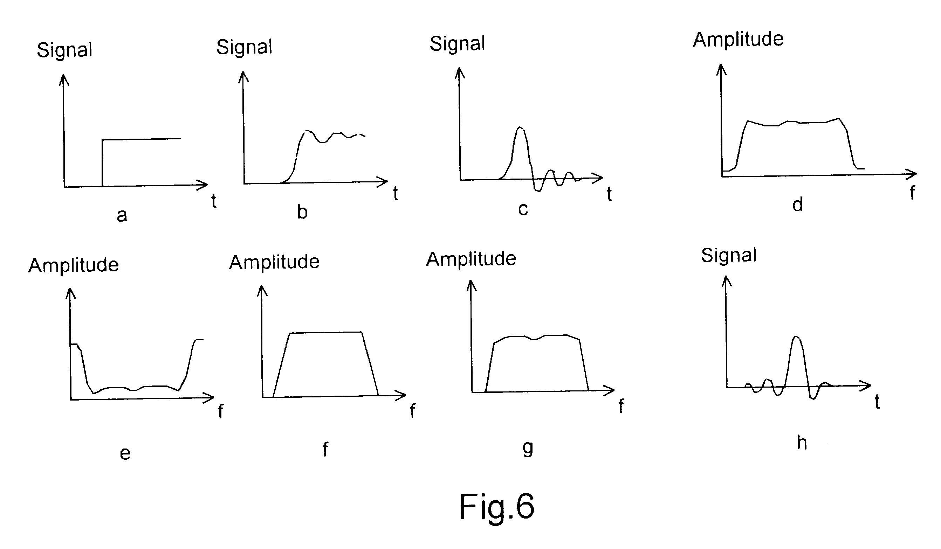

Bei der Ermittlung der Filterkoeffizienten wird so vorgegangen, daß zunächst vom digitalen Signalprozessor DSP ein Sprung- oder Impuls auf den Verstärker 12 gegeben und dessen Sprung- oder Impulsantwort mit dem Mikrofon 20 am Hörort 18 gemessen wird. Hierzu zeigt Fig. 6 a das ursprüngliche Signal des Sprung- oder Impulses, wie es am Eingang des Verstärkers 12 auftritt und Fig. 6 b das durch die Übertragungsstecke beeinflußte Signal, wie es am Hörort 18 auftritt. Dieses Signal wird vom digitalen Signalprozessor DSP am Ausgang des Analog-Digital-Wandler DA abgetastet, um die Sprung- oder Impulsantwort zu erhalten. Dann wird das Signal differenziert, wie in Fig. 6 c zeigt.

Da dieses Signal den gesamten Übertragungsweg bestehend aus Digital-Analog-Wandler, Tiefpaß, Verstärker, Schallwandler, akustischer Übertragungsstrekke, Mikrofon, Tiefpaß und Analog-Digital-Wandler durchlaufen hat, sind sämtliche Informationen über den späteren Gesamtsignalweg in dem Meßsignal enthalten. Bei der Wiedergabe ändert sich nur die Reihenfolge der einzelnen Komponenten, über die das Signal zum Schallwandler gelangt. Für den Frequenz- und Phasengang ist dies jedoch unerheblich.

Das in Fig. 6 c dargestellte differenzierte Signal wird anschließend mittels einer diskreten Fourier-Transformation

$$F_m = \sum_{n=0}^{N-1} f_n e^{-j2\pi mn/N}$$

mit m = 0...N - 1 und N = Länge der Sprung- oder Impulsantwort in den Frequenzbereich transformiert, wodurch man den Frequenzgang des gesamten Übertragungsweges erhält, wie er beispielhaft in Fig. 6 d dargestellt ist. Anschließend wird der Frequenzgang invertiert, das heißt der Kehrwert wird gebildet. Die entsprechende Darstellung zeigt Fig. 6 e.

An den Stellen, an denen die Übertragungsfunktion eine sehr kleine Amplitude hat, würden sich durch die Kehrwertbildung sehr große Werte ergeben. Um die Übertragungsfunktion praktisch für ein Filter realisieren zu können, wird sie mit einem Wunschfrequenzgang gewichtet, der den Frequenzgang des Systems bis zu einer praktikablen Grenze von 3 - 6 dB kompensieren soll. Dieser Wunschfrequenzgang ist in Fig. 6 f dargestellt. Die Gewichtung mit dem Wunschfrequenzgang erfolgt dadurch, daß der Amplitudengang gemäß Fig. 6 e multipliziert und der Phasengang addiert wird. Der Amplitudengang ist innerhalb eines Bereiches zwischen der oberen und unteren Kompensationsfrequenz gleich Eins. An den Grenzen fällt er mit der Fensterfunktion auf Null. Diese Fensterfunktion bestimmt die Welligkeit des resultierenden Frequenzganges sowie die Länge der Sprung- oder Impulsantwort des kompensierenden Filters. Sie ist damit entscheidend für die Qualität des Ergebnisses.

Das Ergebnis der Multiplikation ist somit ein Frequenzgang eines Filters, das den Übertragungsweg in seiner Gesamtheit so kompensiert, daß es dem Wunschfrequenzgang an den Stützstellen der Fourier-Transformation entspricht. Das sich daraus ergebende Produkt ist in Fig. 6 g dargestellt. Aus dem Produkt von Wunsch- und Kehrwert der Fourier-Transformation wird durch Rücktransformation

$$f_n = 1/N \sum_{m=0}^{N-1} F_m e^{-j2\pi mn/N}$$

mit n = 0...N - 1 und N = Länge der Sprung- oder Impulsantwort die Sprung- oder Impulsantwort des Kompensationsfilters. Diese in Fig. 6 h dargestellte Sprung- oder Impulsantwort ist gleich den Koeffizienten eines FIR-Filters. Um die Filterung zu verkürzen, kann jedoch auch ein IIR-Filter aus der Sprung- oder Impulsantwort berechnet werden.

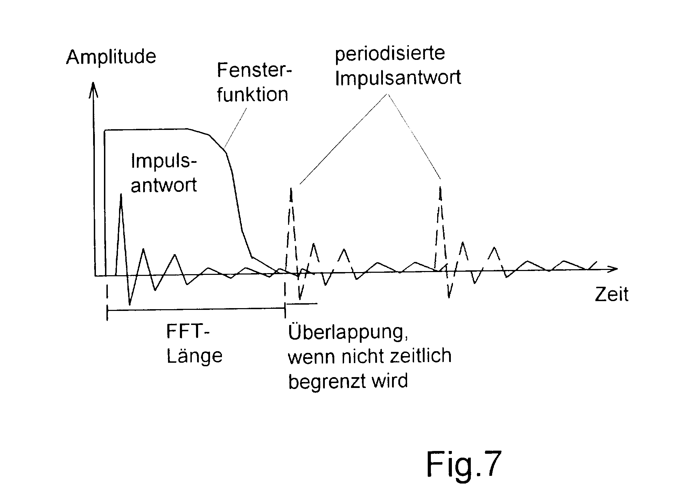

Gemäß Fig. 7 wird die Sprung- oder Impulsantwort aus der differenzierten Sprung- oder Impulsantwort gemäß Fig. 6 c mit einer Fensterfunktion multipliziert. Diese Fensterfunktion beeinflußt nur den rechten Teil der Sprung- oder Impulsantwort. Dadurch ist sichergestellt, daß die Sprung- oder Impulsantwort bei der Fouriertransformation periodisiert werden kann, ohne daß durch das einfache Abschneiden der Sprung- oder Impulsantwort Fehler im Frequenzbereich entstehen. Bei einer Fouriertransformation wird immer von periodisch fortgesetzten Signalen ausgegangen. Sind die Signale nicht periodisch, so müssen sie mit der Periode der Fouriertransformation periodisiert werden. Fehler könnten entstehen, wenn die Sprung- oder Impulsantwort innerhalb der für die Fouriertransformation möglichen Länge noch nicht abgeklungen ist.

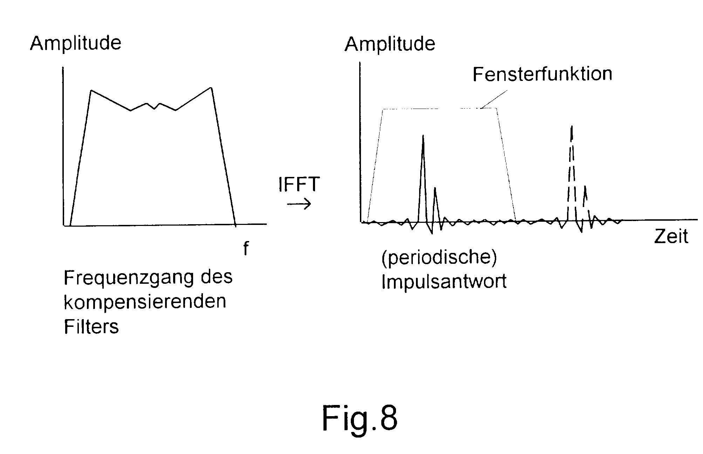

Die Darstellung in Fig. 8 zeigt die Behandlung der durch inverse Fouriertransformation erhaltenen Sprung- oder Impulsantwort, die der Funktion des kompensierenden Filters entspricht. Bei der inversen Fouriertransformation wird der in Fig. 6 h dargestellte Frequenzgang in eine periodische Funktion überführt. Mit der Fensterfunktion wird aus der periodischen Funktion eine Periode selektiert. Durch die Form der Fensterfunktion wird sichergestellt, daß die Funktion nicht einfach an den Enden abgeschnitten wird, sondern sanft ausläuft.

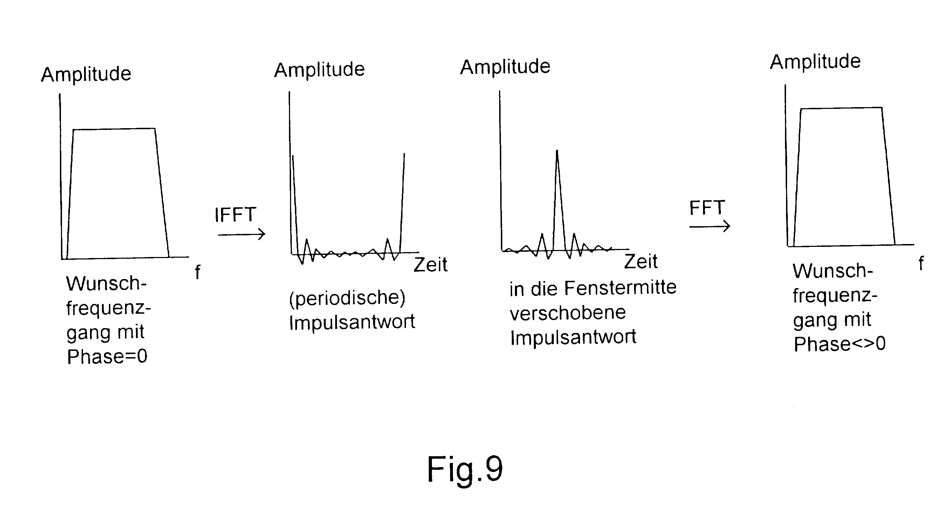

Fig. 9 veranschaulicht schließlich als Signal- und Frequenzdiagramm eine Möglichkeit, die Phasenlage des Wunschfrequenzgangs an die Phase der Sprung- oder Impulsantwort des Meßsignals anzupassen. Dabei wird zunächst der Wunschfrequenzgang mit der Phase Null durch inverse Fouriertransformation in den Zeitbereich transformiert. Anschließend wird die periodische Sprung- oder Impulsantwort um eine halbe Fourierperiode in die Fenstermitte verschoben und wieder in den Frequenzbereich transformiert. Der Wunschfrequenzgang besitzt dann die richtige Phasenlage.

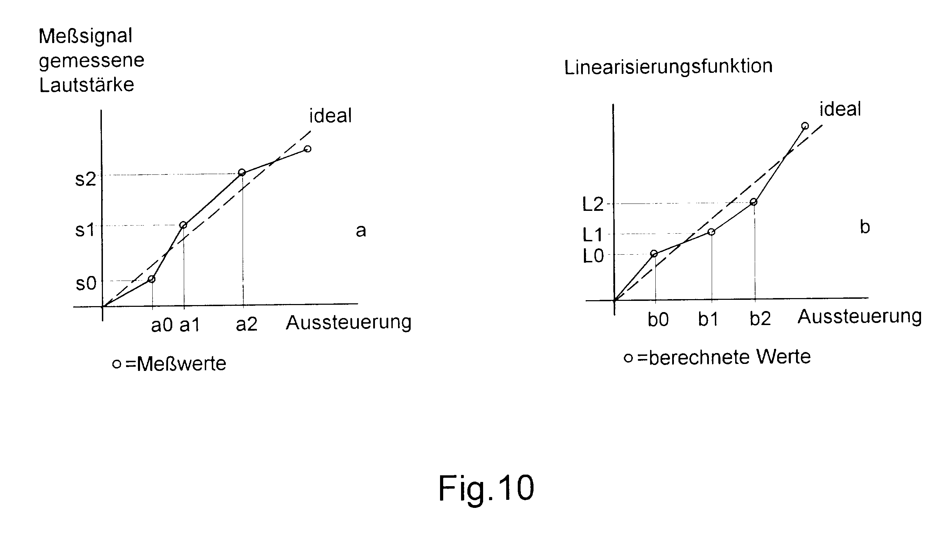

Fig. 10 zeigt ein Diagramm für eine Linearisierungsfunktion der Aussteuerung. In Fig. 10 a sind die gemessenen Amplituden s0, s1, s2, ... si von Meßsignalen bei unterschiedlicher Aussteuerung a0, a1, a2, ... ai aufgetragen und die Meßwerte durch eine Interpolationsfunktion zu einer Aussteuerungskennlinie verbunden. Gestrichelt ist ferner eine Idealkennlinie I(i) dargestellt, die einer linearen Abhängigkeit von Amplitude zu Aussteuerung entsprechen würde. Durch Division der Idealkennlinie 1(i) durch die Aussteuerungskennlinie a(i) wird eine in Fig. 10 b dargestellte Linearisierungsfunktion L(i) gewonnen und gespeichert, mit der anschließend die Signalamplitude des Nutzsignal multipliziert wird. Die Amplitude des am Ausgang abgreifbaren Nutzsignals verhält sich dann bei jeder Aussteuerung linear zur Amplitude des Eingangssignals.

**Patentansprüche**

1. Tonfrequenzfilter, bestehend aus wenigstens einem einstellbaren Filterblock (10), welcher in den elektrischen Signalweg einer Tonfrequenzwiedergabeanlage, die wenigstens einen Verstärker (12) und einen Schallwandler (14) umfaßt, einfügbar ist, wobei eine Filterfunktion des Filterblockes (10) durch den Kehrwert des Amplitudenfrequenzgangs und den negativen Wert des Phasenfrequenzganges eines Gesamtsignalweges bemessen ist, der aus dem elektrischen Signalweg der Tonfrequenzwiedergabeanlage und dem akustischen Signalweg zwischen dem Schallwandler und einem Hörort gebildet ist, dadurch gekennzeichnet, daß der Amplitudenfrequenzgang der Filterfunktion durch Kehrwertbildung der von Null verschiedene Bereiche des Amplitudenfrequenzgangs des Gesamtsignalweges bestimmt ist und die Filterfunktion des einstellbaren Filterblockes (10) durch Filterkoeffizienten eingestellt ist, die gleich einer Signalantwort sind, welche auftritt nach Beaufschlagen des Eingangs des elektrischen Signalwegs mit einem Meßsignal, dessen Signalantwort am Hörort gemessen wird, Transformieren der Signalantwort nach Differenzieren durch Fourier-Transformation in den Frequenzbereich, anschließendes Invertieren des Frequenzganges und Wichten mit einem Wunschfrequenzgang und schließlich Rücktransformieren des invertierten und mit dem Wunschfrequenzgang gewichteten Frequenzgangs in den Zeitbereich.

2. Tonfrequenzfilter nach Anspruch 1, dadurch gekennzeichnet, daß der Filterblock (10) als Digitalfilter ausgebildet ist, das in einen Tieftonweg (24) und einen Mittel- und Hochtonweg (26) aufgeteilt ist und daß im Tieftonweg (24) eine Unterabtastung erfolgt.

3. Tonfrequenzfilter nach Anspruch 1, dadurch gekennzeichnet, daß der Mittel- und Hochtonweg (26) einen ersten Hochpaß (HP1), ein Mittel- und Hochton-Kompensationsfilter (FK2) und einen zweiten Hochpaß (HP2) umfaßt und daß der Tieftonweg (26) ein erstes Tiefpaßfilter (TP1), eine Unterabtaststufe (US), ein Tiefton-Kompensationsfilter (FK1), eine Überabtaststufe (ÜS) und ein zweites Tiefpaßfilter (TP2) umfaßt.

4. Tonfrequenzfilter nach einem der Ansprüche 1 bis 3, dadurch gekennzeichnet, daß bei einer Stereoanlage mit zwei Kanälen (R, L) jeder Kanal einen gesonderten Filterblock (F1, F4) umfaßt und daß zwischen dem Eingang des Filterblockes (F1) des einen Kanals (R) und dem Ausgang des Filterblockes (F4) des anderen Kanals (L) jeweils ein weiterer Filterblock (F2, F3) angeordnet ist und die Filterfunktionen der weiteren Filterblöcke (F2, F3) so bestimmt sind, daß sie das kreuzweise Übersprechen zwischen den Kanälen (R, L) des Gesamtsignalweges kompensieren.

5. Tonfrequenzfilter nach einem der Ansprüche 1 bis 4, dadurch gekennzeichnet, daß jeder Filterblock (10, F1, F2, F3, F4) oder jeder Tonweg (24, 26) eines Filterblockes (10) einen Signalprozessor (DSP) mit Speichern (RAM, ROM) sowie einen Tiefpaß (TP) mit anschließendem Analog-Digital-Wandler (AD) am Eingang und einen Digital-Analog-Wandler (DA) mit anschließendem Tiefpaß (TP) am Ausgang umfaßt, wobei der Speicher (RAM, ROM) ein den Signalprozessor steuerndes Filterprogamm und die Filterfunktion definierende Filterkoeffizienten enthält.

6. Tonfrequenzfilter nach einem der Ansprüche 1 bis 5, dadurch gekennzeichnet, daß die Filterfunktion näherungsweise durch ein gebrochenrationales Polynom mit Filterkoeffizienten $a_0,...,a_N$, $b_1,. ..b_N$ als

$$A(z) = \frac{a_0 + a_1 z^{-1} + a_2 z^{-2} + \ldots + a_{N-1} z^{-(N-1)} + a_N z^{-N}}{1 + b_1 z^{-1} + b_2 z^{-2} + \ldots + b_{N-1} z^{-(N-1)} + b_N z^{-N}}$$

dargestellt ist.

7. Tonfrequenzfilter nach Anspruch 6, dadurch gekennzeichnet, daß die Ordnungszahl des Filters entsprechend der Anzahl der Filterkoeffizienten gerade so groß ist, daß die Abweichungen vom idealen Frequenzgang maximal 3 dB betragen.

8. Verfahren zur Bestimmung der Filterfunktion eines Tonfrequenzfilters, welches in den elektrischen Signalweg einer Tonfrequenzwiedergabeanlage, die wenigstens einen Verstärker und einen Schallwandler umfaßt, einfügbar ist, wobei Amplitudenfrequenzgang der Filterfunktion durch den Kehrwert des Amplitudenfrequenzgangs und ein Phasenfrequenzgang der Filterfunktion durch den negativen Wert des Phasenfrequenzganges eines Gesamtsignalweges bemessen ist, der aus dem elektrischen Signalweg der Tonfrequenzwiedergabeanlage und dem akustischen Signalweg zwischen dem Schallwandler und einem Hörort gebildet ist, dadurch gekennzeichnet, daß der Eingang des elektrischen Signalwegs in Vorversuchen mit einem Meßsignal beaufschlagt wird, dessen Signalantwort am Hörort gemessen wird, daß die Signalantwort nach Differenzieren durch Fourier-Transformation in den Frequenzbereich transformiert wird, daß anschließend der Frequenzgang invertiert und mit einem Wunschfrequenzgang gewichtet wird und daß schließlich durch Rücktransformation des invertierten und mit dem Wunschfrequenzgang gewichteten Frequenzgangs in den Zeitbereich die Signalantwort des Tonfrequenzfilters bestimmt wird, die gleich den Koeffizienten eines Filters ist.

9. Verfahren nach Anspruch 8, dadurch gekennzeichnet, daß das Meßsignal eine Sprungfunktion oder eine Impulsfunktion der zeitlichen Länge größer Null ist und die nach Durchlaufen des unkorrigierten Gesamtsignalweges am Hörort erhaltene Sprung- oder Impulsantwort differenziert wird.

10. Verfahren nach Anspruch 9, dadurch gekennzeichnet, daß die differenzierte Sprung- oder Impulsantwort mit einer an der Seite sanft auslaufenden Fensterfunktion multipliziert wird, deren zeitliche Länge kleiner oder gleich der Periode der Fourier-Transformation ist.

11. Verfahren nach einem der Ansprüche 8 bis 10, dadurch gekennzeichnet, daß die nach Rücktransformation in den Zeitbereich erhaltene Signalantwort, die die Signalantwort des korrigierenden Tonfrequenzfilters darstellt, mit einer weiteren, an beiden Seiten sanft auslaufenden Fensterfunktion multipliziert wird, deren zeitliche Länge kleiner oder gleich der Periode der Fourier-Transformation ist.

12. Verfahren nach einem der Ansprüche 8 bis 11, dadurch gekennzeichnet, daß die Phase des Wunschfrequenzganges an die Phase der in den Frequenzbereich transformierten Signalantwort angepaßt wird, indem der Wunschfrequenzgang mit Phase Null in den Zeitbereich transformiert wird, anschließend um eine halbe Periode der Fourier-Transformation verschoben wird und anschließend in den Frequenzbereich zurücktransformiert wird.

13. Verfahren nach einem der Ansprüche 8 bis 12, dadurch gekennzeichnet, daß der Frequenzgang in Betrag und Phase eines zur Messung benutzten Meßaufnehmers invertiert und mit dem Wunschfrequenzgang multipliziert wird.

14. Verfahren nach einem der Ansprüche 8 bis 13, dadurch gekennzeichnet, daß mehrere Messungen mit unterschiedlichen Signalpegeln durchgeführt werden und daraus eine Aussteuerungskennlinie ermittelt wird, und daß durch Division einer Idealkennlinie durch die Aussteuerungskennlinie eine Linearisierungsfunktion gewonnen und gespeichert wird, mit der anschließend die Signalamplitude des Nutzsignals multipliziert wird.

**Claims**

1. Audio-frequency filter, consisting of at least one adjustable filter unit (10), which can be inserted into the electrical signal path of an audio-frequency playback installation, which comprises at least one amplifier (12) and one sound transducer (14), a filter function of the filter unit (10) being assessed by the reciprocal of the amplitude frequency characteristic and the negative value of the phase frequency characteristic of a total signal path, which is formed of the electrial signal path of the audio-frequency playback installation and the acoustic signal path between the sound transducer and a hearing location, characterized in that the amplitude frequency characteristic of the filter function is determined by forming the reciprocal of the regions other than zero of the amplitude frequency characteristic of the total signal path and the filter function of the adjustable filter unit (10) is set by filter coefficients which are equal to a signal response that occurs after loading of the input of the electrial signal path with a measurement signal, the signal response of which is measured at the hearing location, transforming of the signal response after differentiation by Fourier transformation into the frequency range, subsequent inverting of the frequency characteristic and weighting with a desired frequency characteristic and finally back-transformation of the inverted frequency characteristic weighted with the desired frequency characteristic into the time range.

2. Audio-frequency filter according to claim 1, characterized in that the filter unit (10) is constructed as a digital filter, which is divided into a low-tone path (24) and a medium and high-tone path (26) and that an under-scanning is carried out in the low-tone path (24).

3. Audio-frequency filter according to claim 1, characterized in that the medium and high-tone path (26) comprises a first high-pass (HP1), a medium and high-tone compensation filter (FK2) and a second high-pass (HP2), and that the low-tone path (26) comprises a first low-pass filter (TP1), an under-scanning stage (US), a low-tone compensation filter (FK1), an over-scanning stage (ÜS) and a second low-pass filter (TP2).

4. Audio-frequency filter according to one of claims 1 to 3, characterized in that, in the case of a stereo installation comprising two channels (R, L), each channel comprises a separate filter unit (F1, F4), and that between the input of the filter unit (F1) of the one channel (R) and the output of the filter unit (F4) of the other channel (L), a further filter unit (F2, F3) is disposed in each case, and that the filter functions of the further filter units (F2, F3) are so determined that they compensate the cross talk between the channels (R, L) of the total signal path.

5. Audio-frequency filter according to one of claims 1 to 4, characterized in that each filter unit (10, F1, F2, F3, F4) or each tone path (24, 26) of a filter unit (10) comprises a signal processor (DSP) with memories (RAM, ROM) and also a low-pass (TP) with connected analogue-digital converter (AD) at the input and a digital-analogue converter (DA) with connected low-pass (TP) at the output, the memory (RAM, ROM) containing a filter programme controlling the signal processor and filter coefficients defining the filter function.

6. Audio-frequency filter according to one of claims 1 to 5, characterized in that the filter function can be expressed approximately by a broken-rational polynomial having filter coefficients $a_o,...,a_N$, $b_1,...b_N$ as

$$A(z) = \frac{a_0 + a_1 z^{-1} + a_2 z^{-2} + ... + a_{N-1} z^{-(N-1)} + a_N z^{-N}}{1 + b_1 z^{-1} + b_2 z^{-2} + ... + b_{N-1} z^{-(N-1)} + b_N z^{-N}}$$

7. Audio-frequency filter according to claim 6, characterized in that the ordinal number of the filter corresponding to the number of the filter coefficients is just sufficiently large for the deviations from the ideal frequency characteristic to be at most 3 dB.

8. Method of determining the filter function of an audio-frequency filter which can be introduced into the electrical signal path of an audio-frequency playback installation, which comprises at least one amplifier and one sound transducer, the amplitude frequency characteristic of the filter function being assessed by the reciprocal of the amplitude frequency characteristic and a phase frequency characteristic of the filter function by the negative value of the phase frequency characteristic of a total signal path, which is composed of the electrial signal path of the audio-frequency playback installation and of the acoustic signal path between the sound transducer and a hearing location, characterized in that the input of the electrical signal path is loaded in preliminary tests with a measurement signal, the signal response of which is measured at the hearing location, that the signal response is transformed after differentiation by Fourier transformation into the frequency range, that then the frequency characteristic is inverted and is weighted with a desired frequency characteristic and that, finally, by back-transformation of the inverted frequency characteristic weighted with the desired frequency characteristic into the time range, the signal response of the audio-frequency filter is determined, which is equal to the coefficient of a filter.

9. Method according to claim 8, characterized in that the measurement signal is a step function or an impulse function of the time length greater than zero, and the jump response or impulse response obtained at the hearing location after passing through the uncorrected total signal path is differentiated.

10. Method according to claim 9, characterized in that the differentiated jump response or impulse response is multiplied by a window function tapering gently at the side, the time length of which is smaller than or equal to the period of the Fourier transformation.

11. Method according to one of claims 8 to 10, characterized in that the signal response obtained after back-transformation into the time range, which represents the signal response of the corrected audio-frequency filter, is multiplied by a further window function tapering gently at both sides, the time length of which is smaller than or equal to the period of the Fourier transformation.

12. Method according to one of claims 8 to 11, characterized in that the phase of the desired frequency characteristic is adapted to the phase of the signal response transformed into the frequency range, by the desired frequency characteristic with phase zero being transformed into the time range, then being displaced by a half-period of the Fourier transformation and then being back-transformed into the frequency range.

13. Method according to one of claims 8 to 12, characterized in that the frequency characteristic in value and phase of a measurement pick-up used for the measurement is inverted and multiplied by the desired frequency characteristic.

14. Method according to one of claims 8 to 13, characterized in that several measurements with different signal levels are carried out and from these a control characteristic line is established, and that by division of an ideal characteristic line by the control characteristic line, a linearization function is obtained and is stored, by which the signal amplitude of the useful signal is then multiplied.

## Revendications

1. Filtre de fréquences audio consistant en au moins un bloc filtre réglable (10) qui peut être inséré dans une voie électrique de signal d'une installation de reproduction de fréquences audio, laquelle comprend au moins un amplificateur (12) et un transducteur acoustique (14), une fonction de filtrage du bloc de filtres (10) étant dimensionnée par la valeur inverse de la courbe fréquence-amplitude et la valeur négative de la courbe fréquence-phase d'une voie complète de signal, qui est formée à partir de la voie électrique de signal de l'installation de reproduction de fréquences audio et de la voie acoustique de signal entre le transducteur acoustique et un endroit d'audition, caractérisé en ce que la courbe fréquence-amplitude de la fonction de filtrage est déterminée par la formation de valeur inverse des zones différentes de zéro de la courbe fréquence-amplitude de la voie complète de signal et en ce que la fonction de filtrage du bloc filtre réglable (10) est réglée par des coefficients du filtre qui sont aussi une réponse au signal qui se produit après alimentation à l'entrée de la voie électrique de signal d'un signal de mesure dont la réponse au signal est mesurée à l'endroit d'audition, transformation de la réponse au signal après différentiation par transformation de Fourier dans la gamme de fréquences, ensuite inversion de la courbe de fréquences et pondération avec une courbe désirée de fréquences et enfin transformation inverse de courbe de fréquences inversée et pondérée avec la courbe désirée de fréquences dans le domaine du temps.

2. Filtre de fréquences audio suivant la revendication 1, caractérisé en ce que le bloc filtre (10) est un filtre numérique qui est partagé en une voie à fréquences basses (24) et en une voie à fréquences audio moyennes et hautes (26) et en ce que, dans la voie à fréquences basses (24) suit un sous-échantillonneur.

3. Filtre de fréquences audio suivant la revendication 1, caractérisé en ce que la voie à fréquences audio moyennes et hautes (26) comprend un premier filtre passe-haut (HP1), un filtre de compensation des fréquences audio hautes (FK2) et un second filtre passe-haut (HP2) et en ce que la voie des fréquences audio basses (24) comprend un premier filtre passe-bas (TP1), un étage de sous-échantillonnage (US), un filtre de compensation des fréquences audio basses (FK1), un étage de sur-échantillonnage (ÜS) et un second filtre passe-bas (TP2).

4. Filtre de fréquences audio suivant l'une des revendications 1 à 3, caractérisé en ce que, dans une installation stéréo à deux canaux (R, L), chaque canal comprend un bloc filtre séparé (F1, F4) et en ce qu'entre l'entrée du bloc filtre (F1) d'un canal (R) et la sortie du bloc filtre (F4) de l'autre canal (L), est monté un autre bloc filtre (F2, F3), et les fonctions de filtrage des autres blocs filtres (F2, F3) sont déterminées de manière qu'elles compensent la diaphonie croisée entre les canaux (R, L) de la voie complète de signal.

5. Filtre de fréquences audio suivant l'une des revendications 1 à 4, caractérisé en ce que chaque bloc filtre (10, F1, F2, F3, F4) ou chaque voie audio (24, 26) d'un bloc filtre (10) comprend un processeur de signaux (DSP) avec mémoires (RAM, ROM) ainsi qu'un filtre passe-bas (TP) avec convertisseur analogique-mumérique associé (AD) à l'entrée et un convertisseur numérique-analogique (DA) avec un filtre passe-bas associé (TP) à la sortie, la mémoire (RAM, ROM) contenant un programme de commmande du processeur de signaux et des coefficients de filtrage définissant la fonction de filtrage.

6. Filtre de fréquences audio suivant l'une des revendications 1 à 5, caractérisé en ce que la fonction de filtrage est représentée de façon approximative par un polynome fractionné avec des coefficients de filtrage $a_0, ..., a_N, b_1, ..., b_N$: tel que

$$A(z) = \frac{a_0 + a_1 z^{-1} + a_2 z^{-2} + ... + a_{N-1} z^{-(N-1)} + a_N z^{-N}}{1 + b_1 z^{-1} + b_2 z^{-2} + ... + b_{N-1} z^{-(N-1)} + b_N z^{-N}}$$

7. Filtre de fréquences audio suivant la revendication 6, caractérisé en ce que le nombre ordinal du filtre correspondant au nombre de coefficients de filtrage est exactement aussi grand que se chiffrent les écarts de la courbe de fréquence idéale à 3 dB maximum.

8. Procédé de détermination de la fonction de filtrage d'un filtre de fréquences audio, qui peut être inséré dans une voie électrique de signal d'une installation de reproduction de fréquences audio qui comprend au moins un amplificateur et un transducteur acoustique, une courbe fréquence-amplitude de la fonction de filtrage étant dimensionnée par la valeur inverse de la courbe fréquence-amplitude et une courbe fréquence-phase étant dimensionnée par la valeur négative de la courbe fréquence-phase d'une voie complète de signal, qui est formée à partir de la voie électrique de signal de l'installation de reproduction de fréquences audio et de la voie acoustique de signal entre le transducteur acoustique et un endroit d'audition, caractérisé en ce que l'entrée de la voie électrique de signal est alimentée dans les essais préliminaires par un signal de mesure dont la réponse au signal est mesurée à l'endroit d'audition, en ce que la réponse au signal est transformée après différenciation par transformation de Fourier en domaine de fréquences, en ce qu'ensuite la courbe de fréquence est inversée et pondérée avec une courbe voulue de fréquences et en ce qu'enfin, par transformation inverse de la courbe de fréquences inversée et pondérée avec la courbe voulue de fréquences dans le domaine du temps, la réponse au signal du filtre de fréquences audio est déterminée, lequel est égal aux coefficients d'un filtre.

9. Procédé suivant la revendication 8, caractérisé en ce que le signal de mesure est une fonction de sauts ou une fonction impulsionnelle de longueur temporelle supérieure à zéro et la réponse en sauts ou impulsionnelle obtenue, après passage dans la voie complète de signal non corrigée, à l'endroit d'audition est différenciée.

10. Procédé suivant la revendication 9, caractérisé en ce que la réponse en sauts ou impulsionnelle différenciée est multipliée par une fonction fenêtre se terminant en pente douce sur le côté, dont la longueur temporelle est plus petite ou égale à la période de la transformation de Fourier.

11. Procédé suivant l'une des revendications 8 à 10, caractérisé en ce que la réponse au signal conservée après transformation inverse dans la plage de temps, qui représente la réponse au signal du filtre de fréquences audio correcteur, est multipliée par une autre fonction fenêtre se terminant en pente douce des deux côtés, dont la longueur temporelle est plus petite ou égale à la période de la transformation de Fourier.

12. Procédé suivant l'une des revendications 8 à 11, caractérisé en ce que la phase de la courbe désirée de fréquences est adaptée à la phase de la réponse au signal transformée dans la plage de fréquences, dans laquelle la courbe désirée de fréquences est transformée avec une phase nulle dans la plage de temps, ensuite décalée d'une demi-période de la transformation de Fourier et, enfin, retransformée dans la plage de fréquences.

13. Procédé suivant l'une des revendications 8 à 12, caractérisé en ce que la courbe de fréquences, en valeur et en phase, d'un capteur de mesure utilisé pour la mesure est inversée et multipliée par la courbe désirée de fréquences.

14. Procédé suivant l'une des revendications 8 à 13, caractérisé en ce que plusieurs mesures sont réalisées avec différents niveaux de signal et qu'en conséquence est définie une caractéristique de réglage, et en ce que, par division d'une caractéristique idéale par la caractéristique de réglage, une fonction de linéarisation est obtenue et mise en mémoire, par laquelle est ensuite multipliée l'amplitude de signal du signal réel.

EP 0 687 126 B1

Fig.1

Fig.2

EP 0 687 126 B1

Fig.3

Fig.4

EP 0 687 126 B1

Fig.5

Fig.6

Amplitude

Fensterfunktion

Impulsantwort

periodisierte
Impulsantwort

FFT-
Länge

Überlappung,
wenn nicht zeitlich
begrenzt wird

Zeit

Fig.7

Amplitude

IFFT
→

Amplitude

Fensterfunktion

Zeit

f

Frequenzgang des
kompensierenden
Filters

(periodische)
Impulsantwort

Fig.8

EP 0 687 126 B1

Amplitude

Wunschfrequenzgang mit
Phase=0

IFFT $\longrightarrow$

Amplitude

Zeit

(periodische)
Impulsantwort

Amplitude

Zeit

in die Fenstermitte
verschobene
Impulsantwort

FFT $\longrightarrow$

Amplitude

Wunschfrequenzgang mit
Phase<>0

f

Fig.9

EP 0 687 126 B1

Meßsignal
gemessene
Lautstärke

Linearisierungsfunktion

ideal

s2

s1

a

s0

a0 a1        a2    Aussteuerung

o =Meßwerte

ideal

L2

L1
L0

b

b0    b1    b2    Aussteuerung

o =berechnete Werte

Fig.10

EP 0 687 126 B1